# EUROPÄISCHE PATENTSCHRIFT

(11) **EP 0 943 860 B1**
(45) Veröffentlichungstag und Bekanntmachung des Hinweises auf die Patenterteilung: **27.10.2004**
(21) Anmeldenummer: 99104422.3
(22) Anmeldetag: 05.03.1999
(51) Int. Cl.: F16M 13/00, H05K 7/14

(54) **Befestigungsbausatz für Plattenteile in Gehäusen**
Assembly for mounting plates in casings
Ensemble de fixation de plaques dans des boitiers

(30) Priorität: 18.03.1998 DE 19811727
(43) Veröffentlichungstag der Anmeldung: 22.09.1999
(73) Patentinhaber: Rose-Elektrotechnik GmbH + Co KG Elektrotechnische Fabrik, D-32457 Porta Westfalica (DE)
(72) Erfinder: Schaadt, Dieter B., 32429 Minden (DE); Diekröger, Uwe, 32469 Petershagen (DE)
(74) Vertreter: Philipp, Matthias, Dr.

(56) Entgegenhaltungen:
- DE-A- 4 344 863
- US-A- 3 564 666
- US-A- 4 478 331
- US-A- 5 383 793
- US-A- 5 457 608

## Beschreibung

Die Erfindung betrifft einen Befestigungsbausatz für in einem Gehäuse festlegbare Plattenteile, mit mindestens einer zahnstangenförmigen Traverse mit endseitigen Befestigungsteilen und einem auf der Traverse in Traversen-Längsrichtung verstellbaren Bock mit einer Aufnahme für das Plattenteil.

Ein derartiger Befestigungsbausätz ist aus der US-A-5,457,608 bekannt. Bei diesem ist eine Zahnstange auf einer Gehäusewandung angeklipst und ein mit Rastzähnen, die zu der Zahnung der Zahnstange passen und in diese rastend eingreifen, versehener Bock an einer im Gehäuse einzuschiebenden Platte endseitig befestigt, so daß die Platte in ihrer Lage gegen ein Verschieben gesichert ist.

Weiterhin ist ein Befestigungsbausatz aus der US-A-5,383,793 bekannt, wobei ein Plattenteil zwischen einer Profilschiene und einem Bock mit einer verzahnten Flachstange geklemmt gehalten wird. Die Stange ist an einem Stangenende mit einem angeformten Nutstein in eine Nut der Profilschiene eingesteckt. Der auf der Stange verstellbare Bock greift mit einer Nut über einen Rand des Plattenteiles, das mit dem gegenüberliegenden Plattenrand in einer Nut der Profilschiene gehalten ist. Die Stange ist nicht in einem Gehäuse fixiert und die Plattenbefestigung an dem Bock ist ebenso wie die Traversenhalterung unveränderlich festgelegt.

Aufgabe der Erfindung ist es, den eingangs bezeichneten Bausatz dahingehend zu verbessern, daß damit Platten unterschiedlicher Länge und Breite im Gehäuse gehaltert werden können.

Die Lösung besteht darin, daß mindestens zwei zahnstangenförmige, an beiden Längenenden je eine Befestigungslasche mit Durchsteckloch aufweisende Traversen vorgesehen sind, welche mittels die Befestigungslaschen durchfassende und in Nuten oder Dome des Gehäuses eingreifende Schrauben parallellaufend im Gehäuse festlegbar sind, und daß auf jeder Traverse zwei gegeneinander verstellbare, mit innenseitiger Raste in eine Traversenverzahnung eingreifende hülsenförmige Böcke mit je einer von einem Dom, einem Zapfen oder einer Klammer gebildeten Aufnahme für ein darauf zu befestigendes Plattenteil oder eine oder zwei darauf festlegbare verzahnte Traversen angeordnet sind.

Die Unteransprüche beinhalten Gestaltungsmerkmale, welche vorteilhafte und förderliche Weiterbildungen der Aufgabenlösung darstellen.

Der Befestigungsbausatz gemäß der Erfindung ermöglicht eine variable Befestigung von Plattenteilen der verschiedensten Art, wie Montageplatten, Leiterplatten, Displayplatten o. dgl. in unterschiedlichen Gehäusen, indem dieser Bausatz in sich eine Verstellmöglichkeit auf unterschiedlich große Platten zuläßt. Dabei setzt sich der Bausatz aus einer, zwei oder mehreren zahnstangenartigen Traversen und darauf verschiebbar gelagerten und in jeder verschobenen Stellung verrastbaren Böcken zusammen, die in dom-, zapfen- oder klammerartigen Aufnahmen die jeweilige Platte aufnehmen. In bevorzugter Weise werden in einem Gehäuse für die Plattenteilbefestigung vier auf einem Quadrat angeordnete Traversen vorgesehen, von denen zwei fest im Gehäuse durch Schrauben an Kanälen, Domen o. dgl. befestigt werden und dann zwei quer dazu verlaufende Traversen auf den festen Traversen mit ihren Befestigungsteilen auf deren Böcken aufgesetzt werden, so daß dann diese Traversen mit ihren eigenen Böcken auf den festgelegten Traversen verschoben werden können und zusätzlich noch die Böcke der verschiebbaren Traversen im Abstand zueinander verändert werden, wodurch in zwei Richtungen eine Einstellung der Aufnahmen für die unterschiedlichen Plattenteile erreicht wird.

Dieser Bausatz setzt sich aus wenigen unterschiedlichen Bauteilen zusammen und zwar dem einen Typ der Traverse und dem einen Typ des Bockes mit verschiedenen Aufnahmen in Form von Domen, Zapfen oder Klammern und diese Bauteile sind einfach und kostengünstig herstellbar und ermöglichen eine leichte Montage der unterschiedlichen Plattenteile bei schneller Handhabung und sicherer Lagefixierung. Auf den Zeichnungen ist ein Ausführungsbeispiel der Erfindung dargestellt, welches nachfolgend näher erläutert wird. Es zeigt:
- Fig. 1: eine Perspektive eines aus vier Traversen mit je zwei verstellbaren Böcken bestehenden und in sich verstellbar ausgeführten Befestigungsbausatzes für Plattenteile in Gehäusen,

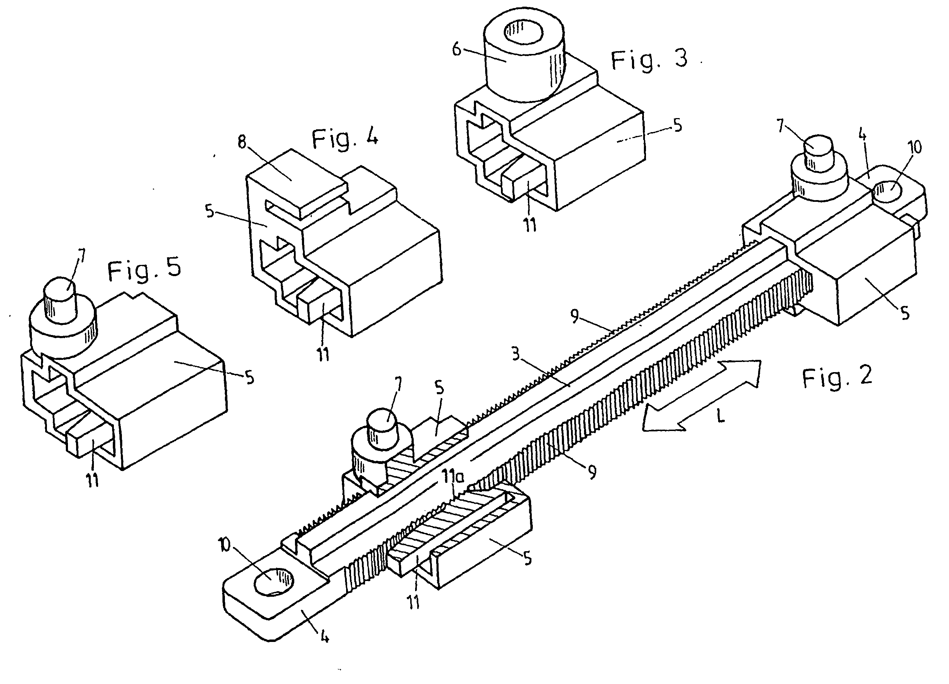

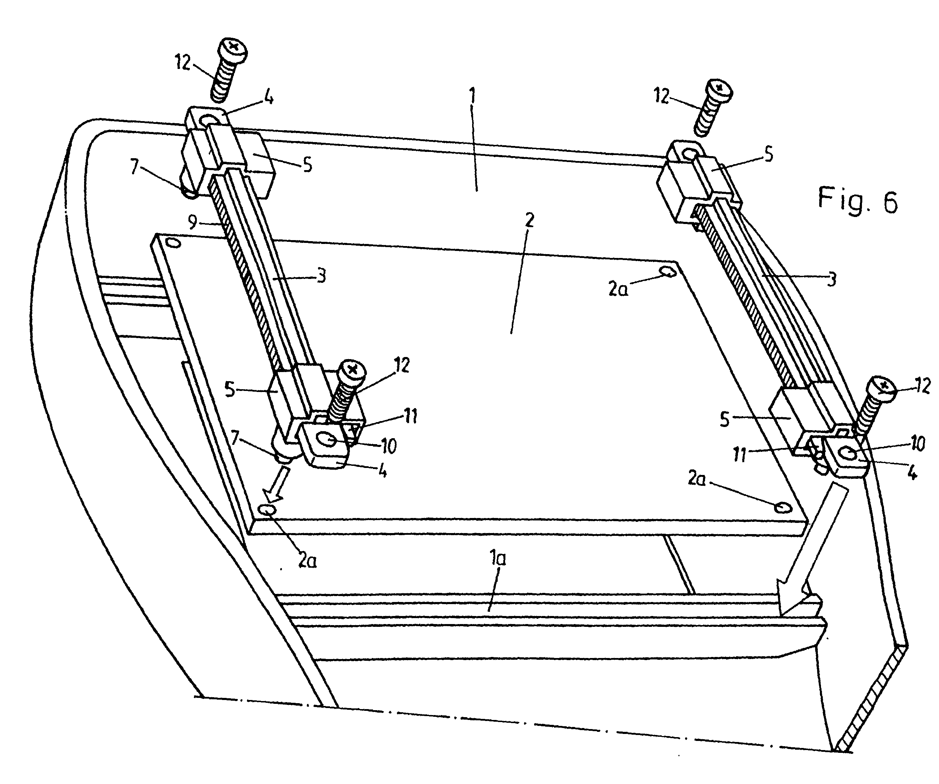

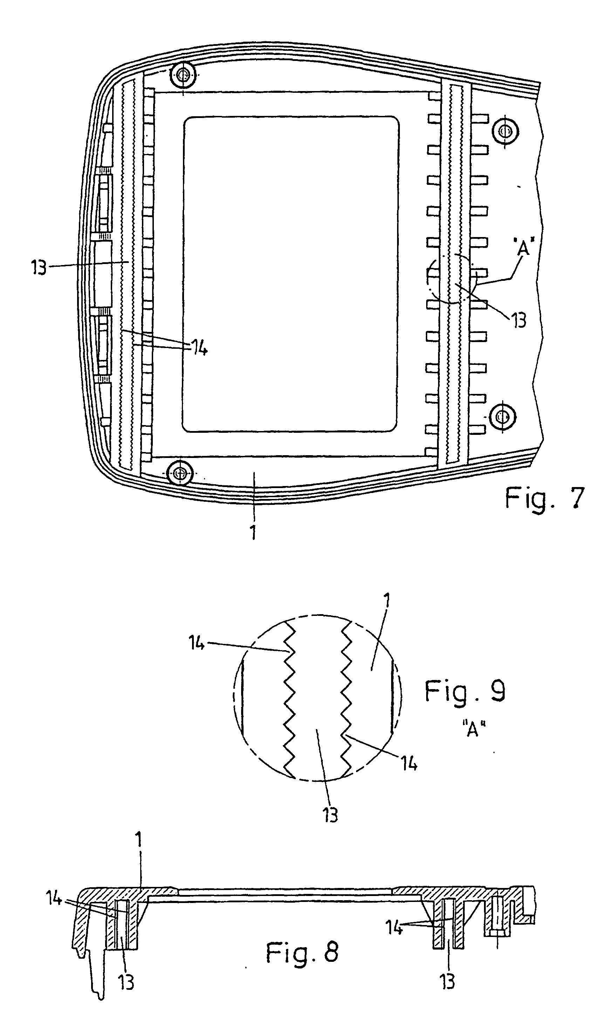

- Fig. 2: eine Perspektive einer Traverse mit zwei Böcken, teilweise geschnitten,
- Fig. 3: Perspektiven von Böcken mit unterschiedlichen bis 5 Plattenteil-Aufnahmen,
- Fig. 6: eine Perspektive eines Gehäuses von hinten gesehen mit Befestigungsbausatz und Plattenteil,
- Fig. 7: eine Rückansicht eines Gehäuseteiles mit verzahnten Schraubkanälen für die Bauteilebefestigung,
- Fig. 8: einen Längsschnitt durch das Gehäuseteil mit Schraubkanälen,
- Fig. 9: einen vergrößerten Ausschnitt "A" des verzahnten Schraubkanales.

Der Befestigungsbausatz für in ein Gehäuse (1), wie Datenerfassungs- und Verarbeitungsgehäuse, Steuertafel, Steuergehäuse o. dgl., aus Aluminium, Polyester, Kunststoff oder Stahlblech einbaubare Plattenteile (2), wie Montageplatte, Leiterplatte, Display o. dgl., weist mindestens eine zahnstangenförmige Traverse (3) mit endseitigen Befestigungsteilen (4) und mindestens einem auf der Traverse (3) in Traversen-Längsrichtung verstellbaren Bock (5) mit Aufnahme (6, 7, 8) für das Plattenteil (2) auf.

Die Traverse (3) ist von einer im Querschnitt eckigen, quadratischen, rechteckigen, T- oder kreisförmigen Stange mit an den beiden sich gegenüberliegenden Stangen-Längsseiten vorgesehener Verzahnung (9) gebildet und hat an beiden Längenenden je eine Befestigungslasche (4) mit einem Durchsteckloch (10). Der eckige Querschnitt der Traverse (3) hält die Böcke (5) verdrehgesichert um die Traverse (3).
Die beiden Befestigungslaschen (4) sind von sich an den Profilquerschnitt der Traverse (3) anschließenden Flachlaschen gebildet.

Jeder Bock (5) ist als die Traverse (3) umgreifenden Schiebehülse (5) mit innenseitiger, in die Verzahnung (9) eingreifender Raste (11) und von der Schiebehülse (5) quer zur Verzahnung (9) abstehender Aufnahme (6, 7, 8) gebildet.

Die Aufnahme an der Schiebehülse (5) läßt sich von einem hülsenförmigen Dom (6), einem Zapfen (7) oder einer Klammer (8) bilden.

Die Schiebehülse (5) umgreift den Profilquerschnitt der Traverse (3) bis auf die Rastseite formschlüssig und wird somit verkantungsfrei für die Verstellung geführt und sicher in der eingestellten Lage gehalten.

Die Raste (11) ist von einer federnden Rastschräge mit mindestens einem in die Verzahnung (9) eingreifenden Rastvorsprung (Rastzahn 11a) gebildet.

Die Traverse (3) und die Schiebehülse (5) bestehen jeweils aus einstückigen Kunststoffteilen.

Der Bausatz setzt sich in einer Ausführung aus zwei mit seinen Befestigungslaschen (4) durch in Nuten (1a) oder Dome des Gehäuses (1) eingreifende Schrauben (12) im Gehäuse festgelegten, parallel laufenden Traversen (3) und zwei auf jeder Traverse (3) gegeneinander verstellbaren Böcken (5) zusammen, wie Fig. 6 zeigt.

Die Böcke (5) können durch die Rast-Verzahnung (11a, 9) auf den beiden Traversen (3) im Abstand zueinander feinfühlig stufenweise auf die jeweilige Größe des Plattenteiles (2) eingestellt werden, welches dann mit einem Loch (2a) um den Dom (6) oder Zapfen (7), oder mit dem Rand in die Klammer (8) eingesteckt und somit an den Böcken (5) gehalten wird.

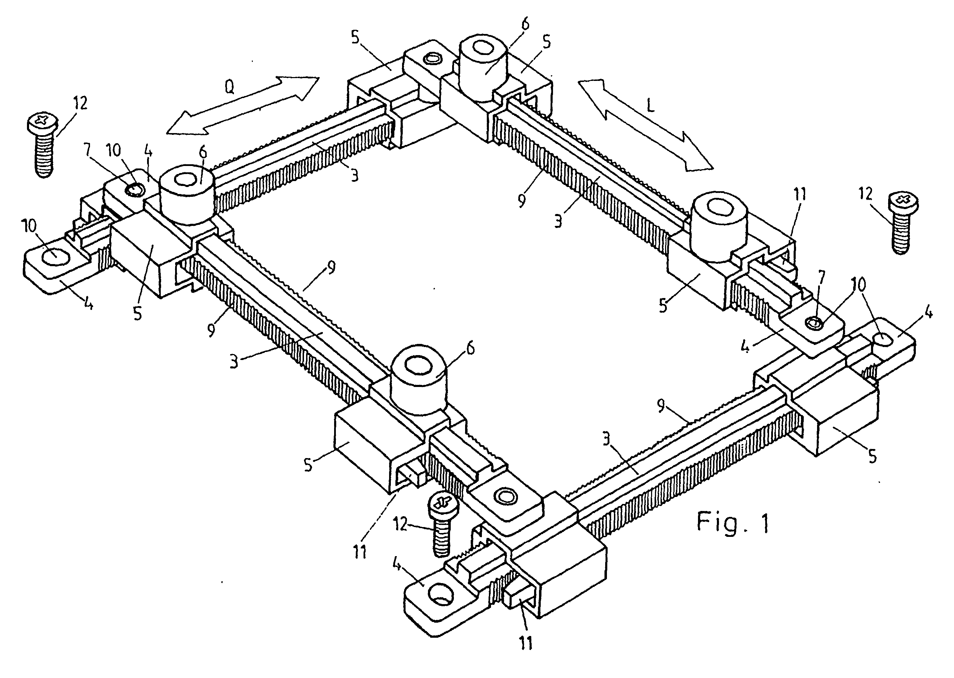

In bevorzugter Weise ist der Bausatz aus vier Traversen (3) mit jeweils zwei Böcken (5) gebildet, wie Fig. 1 zeigt. Hierbei sind zwei parallellaufende Traversen (3) mit ihren Befestigungslaschen (4) durch in die Nuten (1a) oder Dome des Gehäuses (1) eingreifende Schrauben (12) im Gehäuse (1) festgelegt und die beiden anderen parallellaufenden Traversen (3) werden auf oder in den Aufnahmen (6, 7, 8) der Böcke (5) der darunter- oder darüberliegenden Traversen (3) in Traversen-Längsrichtung verschiebbar gehalten.

Somit sind zwei Traversen (3) im Gehäuse (1) festgelegt und die beiden anderen Traversen (3) gegenüber den festen Traversen (3) mit ihrer Länge quer in Richtung (Q) verstellbar und zusätzlich ihre Böcke (5) in Traversen-Längsrichtung (L) verstellbar (Fig. 1), was vier auf den Ecken eines Viereckes (Quadrates oder Rechteckes) liegende Böcke (5) mit auf die jeweilige Größe des Plattenteiles (2) und Lage der Bohrung (2a) im Plattenteil (2) feinfühlig stufenweise einstellbaren Aufnahmen (6, 7, 8) ergibt.

Weiterhin kann das Plattenteil (2) auch mittels zusätzlichen, in die Dome (6) einschraubbaren Schrauben (12) auf den Domen (6) befestigt werden.

Der Bausatz, und zwar die im Gehäuse (1) festzulegenden Traversen (3) können auch höhenmäßig in unterschiedlichen Lagen im Gehäuse (1) gehalten werden, in dem an Gehäuseteilen, wie Lagerprofilen, Montagelager in den gewünschten Höhenlagen angebracht und dann die Traversen (3) mit ihren Befestigungslaschen (4) auf diesen Montagelagern festgelegt werden.

Fig. 7 zeigt ein an der Rückseite (Unterseite) offenes Gehäuse (1) mit Schraubkanälen (13), in die die Schrauben (12) zur variablen Festlegung der Traversen (3), Leiterplatten, Plattenteilen, Displays o. dgl. eingreifen.

Die Schraubkanäle (13) entsprechen den Nuten (1a), sind jedoch verzahnt ausgebildet und haben an beiden Kanal-Längsseiten jeweils eine über die gesamte Kanallänge und Kanaltiefe verlaufende Verzahnung (14).

Diese verzahnten Schraubkanäle (13) sind einstückig in das Gehäuse (1) eingeformt.

## Patentansprüche

1. Befestigungsbausatz für in einem Gehäuse festlegbare Plattenteile, mit mindestens einer zahnstangenförmigen Traverse mit endseitigen Befestigungsteilen und einem auf der Traverse in Traversen-Längsrichtung verstellbaren Bock mit einer Aufnahme für das Plattenteil,
**dadurch gekennzeichnet, daß** mindestens zwei zahnstangenförmige, an beiden Längenenden je eine Befestigungslasche (4) mit Durchsteckloch (10) aufweisende Traversen (3) vorgesehen sind, welche mittels die Befesteigungslaschen (4) durchfassende und in Nuten (1a) oder Dome des Gehäuses (1) eingreifende Schrauben (12) parallellaufend im Gehäuse (1) festlegbar sind, und
daß auf jeder Traverse (3) zwei gegeneinander verstellbare, mit innenseitiger Raste (11) in eine Traversenverzahnung (9) eingreifenden hülsenförmige Böcke (5) mit je einer von einem Dom (6), einem Zapfen (7) oder einer Klammer (8) gebildeten Aufnahme für ein darauf zu befestigendes Plattenteil (2) oder eine oder zwei darauf festlegbare verzahnte Traversen (3) angeordnet sind.

2. Befestigungsbausatz nach Anspruch 1, **dadurch gekennzeichnet, daß** die Traverse (3) von einer Stange mit eckigem Querschnitt, wie Quadrat, Rechteck-, T- oder Kreuzquerschnitt gebildet ist und die endseitigen Befestigungslaschen (4) als an den Profilquerschnitt sich anschließende Flachlaschen ausgeführt sind und die Traversenverzahnung (9) an den beiden sich gegenüberliegenden Stangen-Längsseiten ausgebildet ist.

3. Befestigungsbausatz nach Anspruch 1 oder 2, **dadurch gekennzeichnet, daß** jeder Bock (5) als Schiebehülse gebildet ist und den Profilquerschnitt der Traverse (3) bis auf die Rastseite formschlüssig umgreift.

4. Befestigungsbausatz nach einem der Ansprüche 1 bis 3, **dadurch gekennzeichnet, daß** die innenseitige Raste (11) von einer federnden Rastschräge mit mindestens einem in die Traversenverzahnung (9) eingreifenden Rastvorsprung (Rastzahn) (11a) gebildet ist.

5. Befestigungsbausatz nach einem der Ansprüche 3 bis 4, **dadurch gekennzeichnet, daß** die Traverse (3) und die Schiebehülse jeweils einstückig aus Kunststoff bestehen.

## Claims

1. A fixing kit for plate portions which can be secured in a housing, comprising at least one toothed rack-shaped transverse member with end fixing portions and a support block displaceable on the transverse member in the longitudinal direction thereof and having a mounting means for the plate portion,
**characterised in that** there are provided at least two toothed rack-shaped transverse members (3) which at both longitudinal ends have a respective fixing tongue (4) with a through hole (10) and which can be secured in parallel relationship in the housing (1) by means of screws (12) which pass through the fixing tongues (4) and engage into grooves (1a) or domes of the housing (1) and that arranged on each transverse member (3) are two mutually displaceable sleeve-shaped support blocks (5) which engage with an internal latch (11) into a tooth arrangement (9) on the transverse member and which have a respective mounting means formed by a dome (6), a projection (7) or a clip (8) for a plate portion (2) to be fixed thereon or one or two toothed transverse members (3) which can be secured thereon.

2. A fixing kit according to claim 1 **characterised in that** the transverse member (3) is formed by a bar of angular cross-section such as a square, rectangular, T-shaped or cross-shaped cross-section and the end fixing tongues (4) are in the form of flat tongues adjoining the profile cross-section and the tooth arrangement (9) on the transverse member is provided at the two mutually opposite longitudinal sides of the bar.

3. A fixing kit according to claim 1 or claim 2 **characterised in that** each support block (5) is in the form of a sliding sleeve and embraces the profile cross-section of the transverse member (3) in positively locking relationship except for the latch side.

4. A fixing kit according to one of claims 1 to 3 **characterised in that** the internal latch (11) is formed by a resilient inclined latching portion with at least one latching projection (latching tooth) (11a) engaging into the tooth arrangement (9) of the transverse member.

5. A fixing kit according to one of claims 3 and 4 **characterised in that** the transverse member (3) and the sliding sleeve each integrally comprise plastic material.

## Revendications

1. Ensemble de fixation de plaques dans un boîtier avec au moins une traverse en forme de crémaillère avec des éléments de fixation d'extrémités et un support mobile en translation sur la traverse, dans le sens longitudinal de ladite traverse, avec un réceptacle pour la plaque,
**caractérisé en ce qu'**au moins deux traverses (3) en forme de crémaillère, présentant à chacune des deux extrémités longitudinales une patte de fixation (4) avec un trou de passage (10), sont prévues, lesquelles peuvent être fixées parallèlement dans le boîtier (1) à l'aide de vis (12) qui traversent les pattes de fixation (4) et s'engagent dans des rainures (1a) ou des dôme du boîtier (1) et
**en ce que**, sur chaque traverse (3), sont disposés deux supports (5) en forme de manchons, déplaçables à l'opposé l'un de l'autre, qui engrènent, avec un taquet (11) côté intérieur, dans une denture (9) de traverse, et présentent chacun un réceptacle formé par un dôme (6), un tourillon (7) ou une agrafe (8), pour accueillir une plaque (2) devant y être fixée dessus, ou une ou deux traverses dentées (3) pouvant y être agencées fixement dessus.

2. Ensemble de fixation selon la revendication 1, **caractérisé en ce que** la traverse (3) est formée par une barre à section transversale angulaire, telle qu'une section transversale carrée, rectangulaire, en T ou en croix (?) et que les pattes de fixation (4) d'extrémités sont réalisées en tant que pattes plates faisant suite à la section transversale profilée et que l'assemblage de traverses (9) est réalisé sur les deux côtés longitudinaux, opposés de la barre.

3. Ensemble de fixation selon la revendication 1 ou 2, **caractérisé en ce que** chaque support (5) est conçu en tant que manchon coulissant et agrippe géométriquement la section transversale profilée de la traverse (3) jusqu'au côté d'arrêt.

4. Ensemble de fixation selon l'une des revendications 1 à 3, **caractérisé en ce que** le taquet (11) côté intérieur est formé par un chanfrein d'arrêt faisant ressort, avec au moins une saillie d'arrêt (dent d'arrêt) (11a) qui engrène (?) dans la denture (9) de la traverse.

5. Ensemble de fixation selon l'une des revendications 3 ou 4, **caractérisé en ce que** la traverse (3) et le manchon coulissant sont formés chacun d'une seule pièce en matière plastique.
